# EUROPEAN PATENT APPLICATION

(11) **EP 1 517 329 A2**
(43) Date of publication of application: **23.03.2005**
(21) Application number: 04020653.4
(22) Date of filing: 31.08.2004
(51) Int. Cl.: G11B 33/14, H05K 7/20, F28D 1/00

(54) **Cooling device and electrical equipment equipped with the cooling device**

(30) Priority: 17.09.2003 JP 2003324387
(71) Applicant: Pioneer Corporation, Tokyo 153-0063 (JP)
(72) Inventor: Saito, Katsuomi, Yamada Kawagoe-shi Saitama 350-0822 (JP); Kurata, Isao, Yamada Kawagoe-shi Saitama 350-0822 (JP)
(74) Representative: Grünecker, Kinkeldey, Stockmair & Schwanhäusser Anwaltssozietät

(57) **Abstract**

A car stereo (1) as electrical equipment includes a main body (2) and a cooling device (4). The main body (2) includes a chassis (10). The chassis (10) receives the cooling device (4). The cooling device (4) includes a heat sink (20), an electric fan (21), and a cover (22). The heat sink (20) is thermally connected to a power IC (6) as a heating element and the like. The heat sink (20) is vertically provided on a bottom chassis (11) of the chassis (10). A cover (22) is attached to the heat sink (20) and the bottom chassis (11). The heat sink (20), the cover (22) , and the bottom chassis (11) form an inner closed flow space (100) . The electric fan (21) moves a gas into the flow space (100).

## Description

### Field of the Invention

This invention relates to a cooling device for radiating heat generated by a heating element such as a power IC and electrical equipment equipped with the cooling device.

### Description of the Related Art

For example, a car stereo as electronic equipment is mounted on an instrument panel of a motor vehicle as a mobile unit. The car stereo includes a main body mounted on the instrument panel and a front panel having a display such as a liquid crystal display and various operation buttons.

The main body includes a housing, a playback device for a recording medium such as a cassette tape player, and an AM/FM tuner for receiving radio broad casts. The recording medium for playing on the playback device is loadable and unloadable from the housing. The front panel displays information about operating conditions of the playback device, the AM/FM tuner, and the like. Further, touch switches and push buttons are mounted on the front panel for controlling the playback device, the AM/FM tuner, and the like.

The car stereo is equipped with a cooling device for radiating heat to the outside of the car stereo. Said heat is generated by such as a power IC used for an amplifier for the playback device. The cooling device includes a heat sink thermally connected to such as the power IC, and an electric fan. The housing receives the heat sink. The heat sink is made of metal such as aluminum die-casting. The heat sink is provided outside the power IC.

The electric fan of the cooling device firstly sucks a gas through an opening formed on the housing, secondly passes the gas on a surface of the heat sink of the cooling device, and thirdly exhausts the gas to the outside of the housing through another opening formed on the housing. The gas moved by the electric fan and the heat sink exchange heat at the surface of the heat sink to cool the power IC through the heat sink.

According to structural problems of the conventional cooling device, it cannot sufficiently exhaust the heat generated by the power IC to the outside of the housing. Thereby the heat may gradually spread inside the housing. That brings a problem that especially the recording medium received by the housing for a long time is heated.

An object of this invention is to provide a cooling device for efficiently exhausting such as the heat generated by the heater element mounted in the housing to the outside of the housing, and to provide electrical equipment including the cooling device.

### SUMMARY OF THE INVENTION

In order to attain the object, according to this invention, there is provided a cooling device comprising: a blower for moving a gas; and a gas flow path having an outlet for exhausting the gas to the outside of the cooling device, a flow space for passing the gas, a heating element provided in the flow space, and a regulator for regulating a direction of the gas flow provided in the flow space.

In order to attain the object, according to this invention, there is provided electrical equipment comprising the cooling device; and a housing to receive the cooling device.

The best mode for carrying out a cooling device and electrical equipment including the cooling device according to this invention will be described below. The cooling device of this mode includes a blower, a gas flow path having an outlet for exhausting the gas outside and a flow space for passing the gas. Further, a heating element is provided in the flow space of the gas flow path, and a regulator for regulating a direction of the gas flow in the flow space is provided in the flow space of the gas flow path. Since heat generated by the heater element is radiated by the blower, and the direction of the gas flow in the flow space is regulated by the regulator, the heat absorbing gas can be effectively guided to the outlet. In this way, the heat generated by the heating element is prevented from heating such as the recording medium in the housing.

Further, according to this invention, the heat sink may surround at least a part of the flow space, and the gas moved by the blower may pass along the surface of a base of the heat sink.

Further, a through hole may be provided on the heat sink.

Further, a plurality of fins may be provided on the heat sink, and the through hole may be provided in a space between the fins.

Further, these fins may be provided on the base in a direction perpendicular to the base toward the inside and outside of the flow space.

Further, the electrical equipment may include the cooling device described above and a housing to receive the cooling device.

### BRIEF DESCRIPTION OF THE DRAWINGS

Fig. 1 is an external view of a car stereo as one embodiment of electric equipment according to this invention;
Fig. 2 is a perspective view showing a cooling device mounted on a chassis of the car stereo shown in Fig. 1;
Fig. 3 is an exploded perspective view of the cooling device shown in Fig. 2;
Fig. 4 is a perspective view showing a heat sink and an electric fan of the cooling device being mounted on a chassis shown in Fig. 3;
Fig. 5 is a section view taken on line V-V in Fig. 4;
Fig. 6 is a section view taken on line VI-VI in Fig. 4;
Fig. 7 is a section view taken on line VII-VII in Fig. 4; and
Fig. 8 is a time temperature graph showing curves of recording mediums inserted into conventional devices and embodiments according to this invention.

### DESCRIPTION OF THE PREFERRED EMBODIMENT

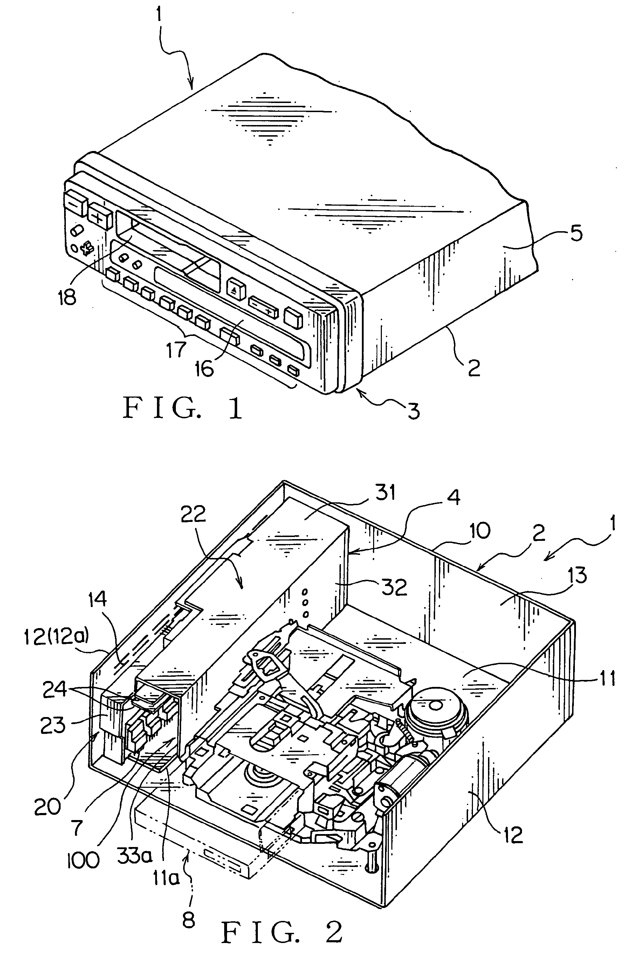

One embodiment of a cooling device and cooling equipment including the cooling device according to this invention will be explained as a car stereo with reference to Figs. 1 to 7. As shown in Fig. 1, a car stereo 1 is mounted on an instrument panel of a vehicle as a mobile unit.

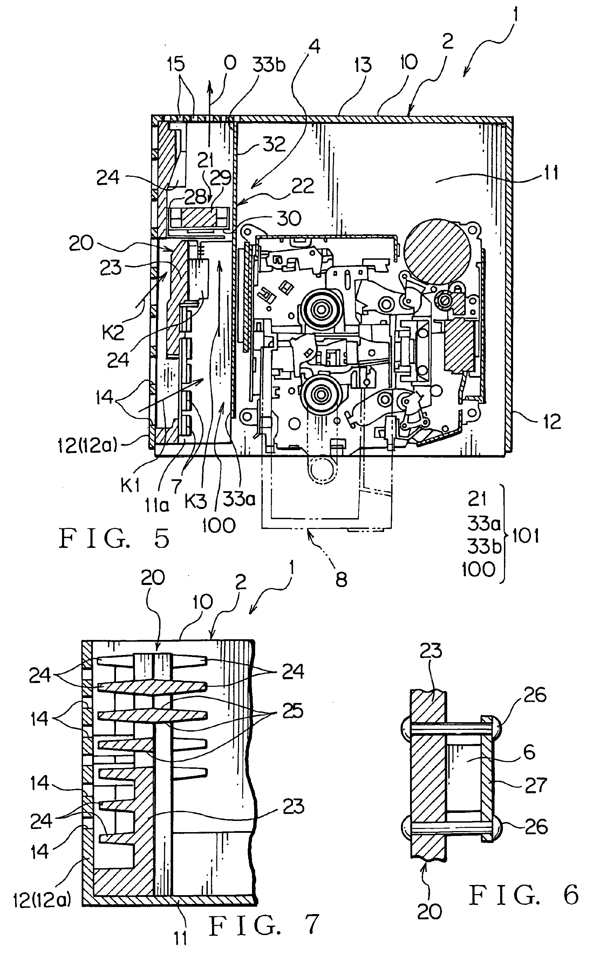

The car stereo 1 includes a main body 2, a console display 3 as shown in Fig. 1, and a cooling device 4 as shown in Figs. 2 and 5.

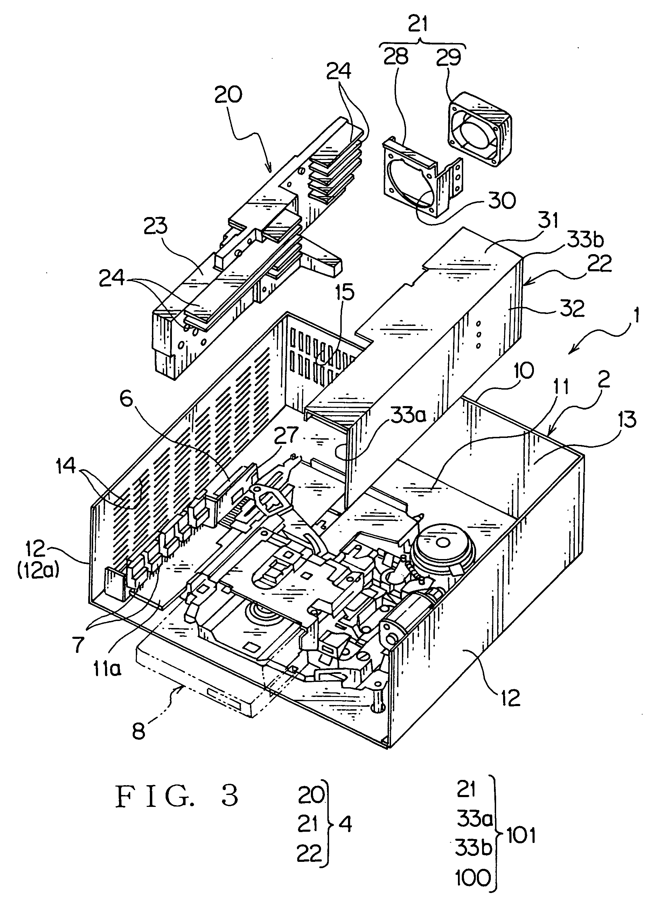

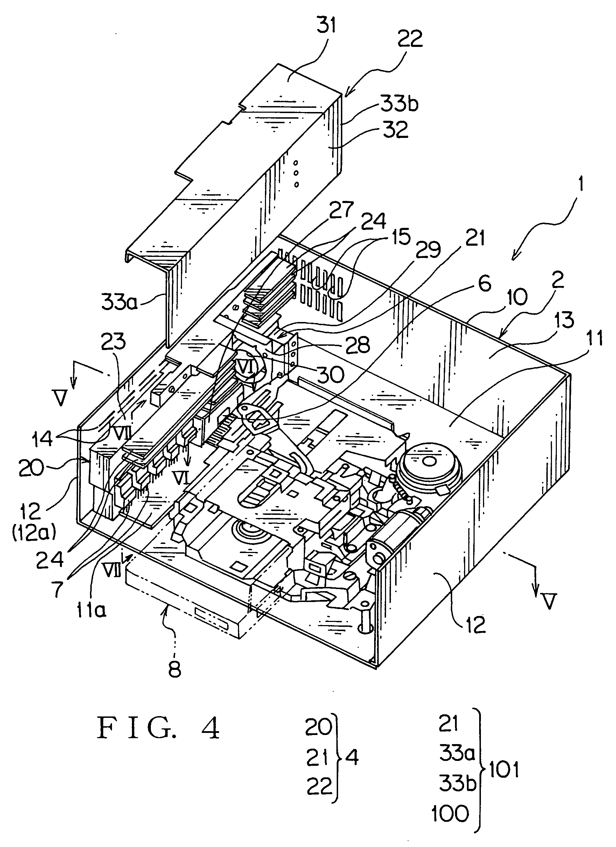

The main body 2 includes a case 5 having a substantially rectangular shape. This case 5 includes a chassis 10 and a top cover (not shown) to cover the chassis 10. The chassis 10 includes an AM/FM radio cassette player, a power IC 6 (power integrated circuit) as a heating element, and a power transistor 7 as shown in Figs. 3 and 4. Namely, a space between the top cover and the chassis 10 in the case 5 receives the radio cassette player, the power IC 6 and the power transistor 7.

The console display 3 is attached to a front surface of the case 5 as shown in the near side of Fig. 1.

The chassis 10 is made of such as sheet metal, and as shown in Figs. 2 to 4, includes a flat bottom chassis 11, side chassis 12 vertically provided from both edges in a width direction of the bottom chassis 11, and a back chassis 13 being vertically provided from another edge of the bottom chassis 11, and connecting the side chassis to each other.

A circuit board 11a is fixed on the bottom chassis 11. A plurality of through holes 14 are formed on one side chassis 12a in the left side of Figs. 2 to 4.

A plurality of through holes 15 are mounted on one side of the back chassis 13 near the side chassis 12a.

In this embodiment, the case 5 receives such as the AM/FM radio cassette player. The cassette player reads information from a cassette tape 8 as a recording medium shown by an alternate long and two short dashes line in Figs. 2 to 5, and outputs sound according to the information. The AM/FM radio tuner receives radio broadcasting and outputs sound.

The case 5 may receive a CD (Compact Disc) player, a MD (Mini Disc) player, a DVD (Digital Versatile Disc) - ROM player and a TV tuner to receive television broadcasting. A user pushes buttons, such as push button 17, mounted on the console display 3, thereby these devices work.

The power ICs 6 and the power transistors 7 are electrically connected to the circuit board 11a. They amplify the sound information reproduced by the cassette player or the AM/FM tuner and output to a speaker mounted on the vehicle with electric power through the circuit board 11a. Therefore, these power ICs 6 and power transistors 7 have more power consumption than other electrical parts, and generates more heat.

The console display 3 includes a graphic information display panel 16 having such as an LCD (Liquid Crystal Display), a plurality of push buttons 17 and the like. The display panel 16 displays a playback monitor of the cassette tape player, a tuning monitor of the AM/FM tuner radio, and the like.

A user can operate the push button 17 by pushing it. This works the AM/FM radio and cassette player and the like received by the case 5.

Further, a cassette tape insertion slot 18 for inserting a tape into and removing it from the main body 2 is provided on the console display 3.The cooling device 4 is installed on the chassis 10 of the main body 2. Namely, the case 5 receives the cooling device 4. The cooling device 4 absorbs heat generated by the power ICs 6 and the power transistors 7, and exhausts the heat to the outside of the car stereo 1 as the main body 2.

As shown in Fig. 2, the cooling device 4 is attached to the circuit board 11a on the bottom chassis 11, the side chassis 12a, and the back chassis 13 near the side chassis 12a. The cooling device 4 includes a heat sink 20, an electric fan 21 as a blower and a cover 22. The heat sink 20 includes a base 23 having a rectangular plane, a plurality of fins 24 and a plurality of through holes 25 (shown in Figs. 5 and 7).

As shown in Fig. 7, the base 23 is vertically provided on the bottom chassis 11 and arranged parallel to the side chassis 12a. The power ICs 6 and the power transistors 7 are mounted on and thus thermally connected to the base 23. For information, "thermally connected" means that heat generated by the power ICs 6 and the power transistors 7 is conducted to the base 23, namely the heat sink 20.

The power transistors 7 are fixed to the base 23 by such screws or the like. As shown in Fig. 6, the power IC 6 is caught in a gap between a metal plate 27 and the base 23. The metal plate 27 is fixed to the base 23 by rivets 26,

The fins 24 are provided on the base 23 in a direction perpendicular to the base 23. The fins 24 are parallel to the bottom chassis 11 and parallel to each other. When the heat sink 20 is attached to the chassis 10, some of fins 24 are provided on the base 23 in a direction perpendicular to the base 23 toward the inside of the chassis 10, namely, the main body 2, while the rest of the fins 24 are standing from the base 23 toward the chassis 12a, namely, outside of the main body 2. In other wards, as shown in Fig. 7, the fins 24 are provided on the base 23 in a direction perpendicular to the base 23 toward the inside and outside of a later-described flow space 100.

The through holes 25 are provided on the base 23. As shown in Fig. 7, the through holes 25 are formed in gaps between the neighboring fins 24.

The electric fan 21 includes a fan case 28, an impeller 29, and a not-shown driving motor. The fan case 28 is formed in a flat shape. An inlet 30 is formed on the fan case 28. The fan case 28 receives the impeller 29 rotatably. The driving motor rotates the impeller 29.

The rotation of the impeller makes the electric fan 21 suck a gas through the inlet 30, and exhaust the gas from a back side of the inlet 30. The inlet 30 of the electric fan 21 is arranged facing the power ICs 6 attached to the base 23. The electric fan 21 is attached to the cover 22 and the heat sink 20. The electric fan 21 is placed in the flow space 100.

The cover 22 is made of sheet metal, and includes integrally a flat base overlap part 31 overlapping with the base 23 and a base parallel part 32 parallel to the base 23. The base overlap part 31 and the base parallel part 32 are perpendicular to each other. The base overlap part 31 is arranged to overlap with an edge of the base 23 opposite to the bottom chassis 11, and to be spaced from and parallel to the bottom chassis 11. The base overlap part 31 is fixed on the edge of the base 23.

The parallel part 32 is arranged parallel to the chassis 12a and fixed on the circuit board 11a. Consequently, a gas flow path 101 is composed of the heat sink 20, the cover 22, and a part of the circuit board 11a. Namely, the cooling device 4 includes the gas flow path 101.

As shown in Figs. 3 to 5, the gas flow path 101 includes the flow space 100 for allowing a gas to flow therethrough and openings 33a, 33b provided at both edges in a longitudinal direction of the cover 22. The power ICs 6 and the power transistors 7 as heating elements are mounted in the flow space 100. The electric fan 21 is also mounted in the flow space 100. Consequently, when the motor rotates the impeller 29, the gas is sucked through the opening 33a to the flow space 100. After flowing in the flow space 100, the gas is conducted to the other opening 33b as the outlet. Then, the conducted gas is exhausted from the opening 33b to the outside of the main body 2, namely, the car stereo 1. In this case, the conducted gas by the electric fan 21 passes through a surface of the base 23. In short, the electric fan 21 moves the gas in the flow space 100. At this time, the base parallel part 32 and the base overlap part 31 regulate a direction of the gas flow in the flow space 100. Namely, the gas moved by the electric fan 21 is regulated in a direction from the opening 33a to the opening 33b. Thus, the electric fan 21 exhausts the heat generated by the power ICs 6 and the power transistors 7 and moves it in the regulated direction. Therefore, the heat can be effectively conducted to the opening 33b. The cover 22 having the base parallel part 32 and the base overlap part 31 is corresponding to the regulators in this embodiment.

The flow space 100 is surrounded by the heat sink 20, the cover 22 and a part of the circuit board 11a. According to this invention, at least a part of the flow space 100 is formed by the heat sink. The electric fan 21 passes the gas through the through hole 25.

According to the cooling device 4, by rotating the impeller 29 of the electric fan 21, the gas is sucked into the flow space 100 through a through hole 14 provided on the chassis 10 along arrows K1 and K2 in Fig. 5, through the through hole 25, and through the opening 33a along an arrow K3 in Fig. 5. Then, heat is exchanged at the surface of the base 23 which is thermally connected to the power ICs 6 and the power transistors 7. The gas sucked by the electric fan 21 is heated by the heat exchange and exhausted through the opening 33b to the outside of the flow space 100 along an arrow O in Fig. 5 and through an through hole 15 provided on the chassis 10 to the outside of the main body 2. Thus, the cooling device 4 cools the power ICs 6 and the power transistors 7.

According to this invention, the power ICs 6 and the power transistors 7 are provided in the flow space 100. The electric fan 21 moves the gas in the flow space 100. The power ICs 6 and the power transistors 7 are thermally connected to the base 23 of the heat sink 20. The gas moved by the electric fan 21 passes through the surface of the base 23.

Therefore, heat can be exchanged between the gas passing through the flow space 100 and the power ICs 6 and the power transistors 7. The heat generated by the power ICs 6 and the power transistors 7 can be radiated to the outside of the flow space 100.

Further, since the base overlap part 31 and the base parallel part 32, namely, the cover 22, regulate the direction of the gas flow in the flow space 100, the heat generated by the power ICs 6 and the power transistors 7 is prevented from spreading to the outside of the flow space 100 in the case 5, namely, to the outside of the cooling device 4. Therefore, the heat generated by the power ICs 6 and the power transistors 7 can be prevented from spreading into the case 5 by receiving the cooling device 4 in the case 5 of the car stereo 1. Thereby the recording medium such as the cassette tape 8 can be prevented from being heated by the heat generated by the power ICs 6 and the power transistors 7.

Further, since the gas passes through the through hole 25 of the heat sink 20, the heat sink 20 can be cooled by the electric fan 21 moving the gas. Therefore, the power ICs 6 and the power transistors 7 are surely cooled through the heat sink 20.

Since a plurality of fins 24 are provided on the base 23 in a direction perpendicular to the base 23, and the through holes 25 are respectively formed in the spaces between the neighboring fins 24, the gas moved by the electric fan 21 reliably passes inside the through holes 25 and tops of fins 24. Since a contact area between the gas moved by the electric fan 21 and the heat sink 20 is increased, the heat sink 20 is reliably cooled by the gas moved by the electric fan 21. Therefore, the power ICs 6 and the power transistors 7 are reliably cooled through the heat sink 20.

Further, since the fins 24 are provided on the base 23 in a direction perpendicular to the base 23 toward both inside and outside of the flow space 100, the contact area between the gas moved by the electric fan 21 and the heat sink 20 is surely increased. Therefore, the power ICs 6 and the power transistors 7 is reliably cooled through the heat sink 20.

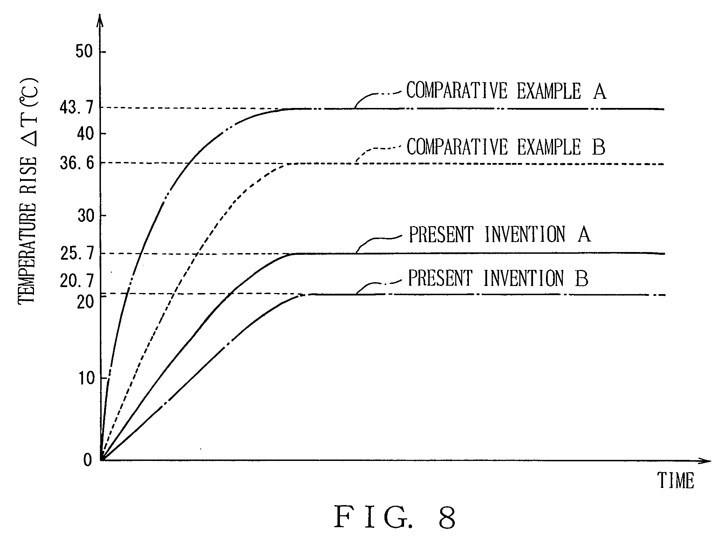

The applicant of this invention confirmed an effect of the cooling device 4 by comparing with the conventional cooling device. The result is shown in Fig. 8.

In this experiment, of which result is shown in Fig. 8, an embodiment A according to this invention is defined as the cooling device 4 having the gas flow path 101 and the like mounted on the car stereo 1 which playbacks the cassette tape 8 as the recording medium. A solid line shown in Fig. 8 corresponds to the embodiment A. This line shows a temperature change of a cassette 8, substantially a half of which is inserted into the main body 2. The temperature change indicates an increase with time during an operation of the car stereo 1.

In this experiment, of which result is shown in Fig. 8, an embodiment B according to this invention is defined as the cooling device 4 having the gas flow path 101 and the like mounted on the car stereo 1 which playbacks a CD (Compact Disc) as the recording medium. An alternate long and short dash line shown in Fig. 8 corresponds to the embodiment B. This line shows a temperature change of the CD, which is inserted into the main body 2. The temperature change indicates an increase with time during an operation of the car stereo 1.

In this experiment, of which result is shown in Fig. 8, a comparative example A is defined as a cooling device just having the electric fan 21, but not having the gas flow path 101 mounted on the car stereo 1 which playbacks the cassette tape 8 as the recording medium. An alternate long and two short dashes line shown in Fig. 8 corresponds to the comparative example A. This line shows a temperature change of the cassette tape 8, substantially a half of which is inserted into the main body 2. The temperature change indicates an increase with time during an operation of the car stereo 1.

In this experiment, of which result is shown in Fig. 8, a comparative example B is defined as a cooling device just having the electric fan 21, but not having the gas flow path 101 mounted on the car stereo 1 which playbacks the CD as the recording medium. A dotted line shown in Fig. 8 corresponds to the comparative example B. This line shows a temperature change of the CD, which is inserted into the main body 2. The temperature change indicates an increase with time during an operation of the car stereo 1.

In the experiment shown in Fig. 8, the electric fan 21 is working. According to Fig. 8, after turning on the car stereo 1, the temperature of the cassette tape 8 of the comparative reference A is saturated at 43.7 degrees centigrade higher than room temperature. Comparing with this, after turning on the car stereo 1, the temperature of the cassette tape 8 of the embodiment A is saturated at 25.7 degrees centigrade higher than room temperature.

Further, after turning on the car stereo 1, the temperature of the CD of the comparative reference B is saturated at 36.6 degrees centigrade higher than room temperature. Comparing with this, after turning on the car stereo 1, the temperature of the CD of the embodiment B is saturated at 20.7 degrees centigrade higher than room temperature.

Thus, the temperature rises of the embodiments A and B is lower than about 60 percent of those of comparative reference A and B. According to above, the temperature rise of the recording medium cooled by the cooling device having the flow space 100 and electric fan 21 provided in the flow space 100 can be reduced by about 60 percent lower than the temperature rise of the recording medium cooled by the cooling device not having the flow space 100.

According to the embodiment, there is provided the cooling device 4 and the car stereo 1 having the cooling device 4 as described below.

### (Note 1)

A cooling device including: the electric fan 21 for moving a gas; and the gas flow path 101 having the opening 33b for exhausting the gas outside and the flow space 100 for passing the gas, characterized in that the power ICs 6, the power transistors 7 and the cover 22 for regulating a direction of the gas flow are provided in the flow space 100 of the gas flow path 101.

### (Note 2)

The cooling device 4 as described in note 1, characterized in that the heat sink 20 surrounds at least a part of the flow space 100, the heat sink 20 includes the base 23 thermally connected to the power ICs 6 and the power transistors 7, and the gas moved by the electric fan 21 passes on the surface of the base 23.

### (Note 3)

The cooling device 4 as described in note 2, characterized in that the through hole 25 are provided on the heat sink 20, and the electric fan 21 moved the gas through the through hole 25.

### (Note 4)

The cooling device 4 as described in note 3, characterized in that the heat sink 20 includes a plurality of fins 24 provided on the base 23 in a direction perpendicular to the base 23, and the through holes 25 are respectively formed in the spaces between the neighboring fins 24.

### (Note 5)

The cooling device 4 as described in note 4, characterized in that the fins 24 are provided on the base 23 in a direction perpendicular to the base 23 toward the inside and outside of the flow space 100.

### (Note 6)

The car stereo 1 characterized in that the car stereo 1 includes the cooling device 4 claimed in any one of claims 1 to 5, and a case 5 to receive the cooling device 4.

In the cooling device 4 as described in Note 1, the power ICs 6 and the power transistors 7 are provided in the flow space 100, and the electric fan 21 moves the gas in the flow space 100. Therefore, the heat is exchanged between the gas passed in the flow space 100 and the power ICs 6 and the power transistors 7. Consequently, the heat generated by the power ICs 6 and the power transistors 7 can be exhausted outside of the flow space 100.

Further, since the gas flow direction in the flow space 100 is regulated by the cover 22, the heat generated by the power ICs 6 and the power transistors 7 is prevented from spreading to the outside of the flow space 100, namely, outside of the cooling device 4. Therefore, when the case 5 of the car stereo 1 receives the cooling device 4, the heat generated by the power ICs 6 and the power transistors 7 is prevented from spreading in the case 5. Thereby, the heat generated by the power ICs 6 and the power transistors 7 is prevented from heating the recording medium such as the cassette tape 8.

In the cooling device 4 as described in Note 2, the power ICs 6 and the power transistors 7 are thermally connected to the base 23 of the heat sink 20, and the electric fan 21 moves the gas through the surface of the base 23. Therefore, the gas moved by the electric fan 21 exchanges the heat generated by the power ICs 6 and the power transistors 7 through the heat sink 20.

Therefore, the heat generated by the power ICs 6 and the power transistors 7 is reliably exhausted to the outside of the flow space 100. Therefore, when the case 5 of the car stereo 1 receives the cooling device 4, the heat generated by the power ICs 6 and the power transistors 7 is prevented from spreading in the case 5. Thereby, the heat generated by the power ICs 6 and the power transistors 7 is prevented from heating the recording medium such as the cassette tape 8.

In the cooling device 4 as described in Note 3, since the gas can pass through the through hole 25 of the heat sink 20, the gas moved by the electric fan 21 cools the heat sink 20 and consequently, reliably cools the power ICs 6 and the power transistors 7 through the heat sink 20.

In the cooling device 4 as described in Note 4, since a plurality of fins 24 are provided on the base 23 in a direction perpendicular to the base 23, and the through holes 25 are respectively formed in the spaces between the neighboring fins 24, the gas moved by the electric fan 21 reliably passes inside the through holes 25 and tops of fins 24. Since a contact area between the gas moved by the electric fan 21 and the heat sink 20 is increased, the heat sink 20 is reliably cooled by the gas moved by the electric fan 21. Therefore, the power ICs 6 and the power transistors 7 are reliably cooled through the heat sink 20.

In the cooling device 4 as described in Note 5, since the fins 24 are provided on the base in a direction perpendicular to the base 23 toward both inside and outside of the flow space 100, the contact area between the gas moved by the electric fan 21 and the heat sink 20 is surely increased. Therefore, the power ICs 6 and the power transistors 7 are reliably cooled through the heat sink 20.

In the car stereo 1 as described in Note 6, the power ICs 6 and the power transistors 7 are provided in the flow space 100 of the cooling device 4, and the electric fan 21 moves the gas in the flow space 100. Therefore, the heat is exchanged between the gas passed in the flow space 100 and the power ICs 6 and the power transistors 7. Consequently, the heat generated by the power ICs 6 and the power transistors 7 can be exhausted outside of the flow space 100.

Further, since the gas flow direction in the flow space 100 is regulated by the cover 22, the heat generated by the power ICs 6 and the power transistors 7 is prevented from spreading to the outside of the flow space 100, namely, outside of the cooling device 4.

Incidentally, the contents of Japanese Patent Application No. 2003-324387 are hereby incorporated by reference.

## Claims

1. A cooling device comprising:
a blower for moving a gas; and
a gas flow path having an outlet for exhausting the gas to the outside of the cooling device, a flow space for passing the gas, a heating element provided in the flow space, and a regulator for regulating a direction of the gas flow provided in the flow space.

2. The cooling device as claimed in claim 1, further comprising:
a heat sink surrounding at least a part of the flow space, said heat sink including a base thermally connected to the heating element,
wherein the gas moved by the blower passes on a surface of the base.

3. The cooling device as claimed in claim 2, wherein through holes are provided on the heat sink, and the gas is passed through the holes by the blower.

4. The cooling device as claimed in claim 3, wherein the heat sink includes a plurality of fins provided on the base in a direction perpendicular to the base, and the holes are respectively formed in the spaces between the neighboring fins.

5. The cooling device as claimed in claim 4, wherein the fins are provided on the base in a direction perpendicular to the base toward the inside and outside of the flow space.

6. Electrical equipment comprising the cooling device claimed in any one of claims 1 to 5; and a housing to receive the cooling device.
